# EUROPEAN PATENT APPLICATION

(11) **EP 2 410 719 A2**
(43) Date of publication of application: **25.01.2012**
(21) Application number: 11157284.8
(22) Date of filing: 08.03.2011
(51) Int. Cl.: H04M 1/02, B29C 65/78, B29C 65/48, B29C 65/50

(54) **Method of making a plastic monitor frame**

(30) Priority: 21.07.2010 TW 099123993
(71) Applicant: Universal Microelectronics Co., Ltd., Taichung 40850 (TW)
(72) Inventor: Lai, Tzu-Sen, Taichung City (TW); Hwang, George, Taichung City (TW); Su, J. Y., Taichung City (TW)
(74) Representative: Wright, Howard Hugh Burnby

(57) **Abstract**

A method of making a monitor frame (10) includes producing separately a transparent plate (2) made of plastic, a middle sheet (3), and a looped framing plate (4) made of plastic and def ining a frame opening (40), the middle sheet (3) having a middle opening (30) extending through opposite first and second surfaces (31,32) thereof; attaching the second surface (32) of the middle sheet (3) to a press face of a tool through a vacuum suction force; moving the press face of the tool to abut against the transparent plate (2) and press the middle sheet (3) against the transparent plate (2) such that the first surface (31) of the middle sheet (3) is adhered flatly to the transparent plate (2); moving the tool away from the second surface (32) of the middle sheet (3); and adhering the looped framing plate (4) to the second surface (32) of the middle sheet (3) such that the frame opening (40) is aligned with the middle opening (30).

## Description

This invention relates to a method of making a monitor frame, and more particularly to a method of making a monitor frame for a movable electronic product.

An outer periphery of a monitor of an electronic product usually has a frame to absorb an external impact, thereby supporting and protecting the monitor. For a movable electronic product, such as a palm-sized game device, a car TV, a cellphone, etc., because the electronic product must move with the user, the likelihood of an external impact is high, which increases the demand for a strong and durable frame. Hence, the frame is an important structural body that can prevent the monitor from being damaged and that can prolong the service life of the electronic product.

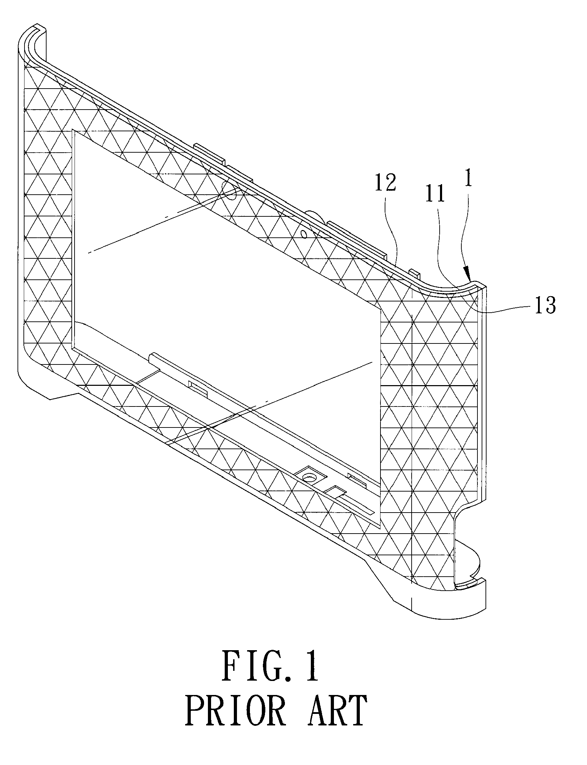

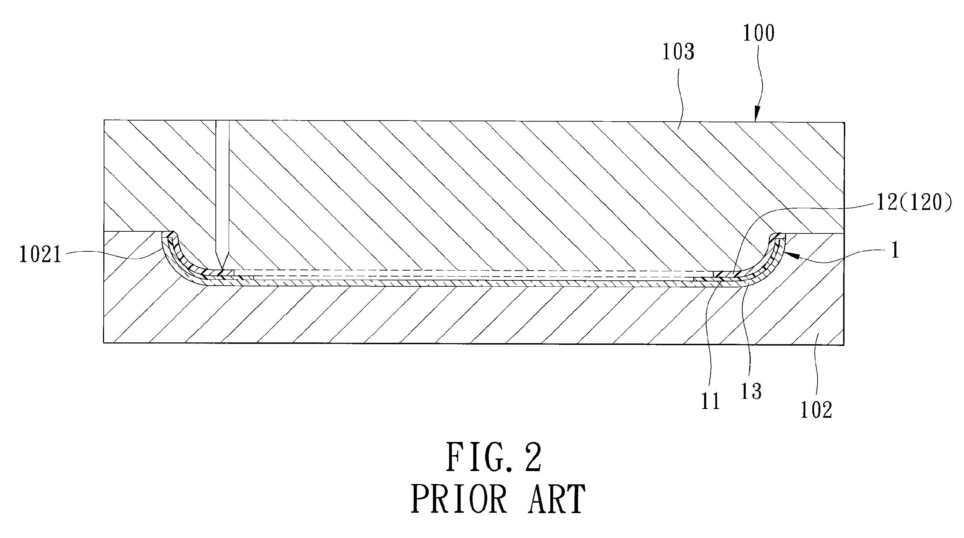

Referring to Figs. 1 and 2, a conventional monitor frame 1 includes a middle sheet 11, and a plastic frame 12 and a transparent acrylic plate 13 connected respectively to two opposite sides of the middle sheet 11. Two opposite lateral sides of the monitor frame 1 are curved.

A conventional method of making the monitor frame 1 includes the steps of first forming a mold 100 that conforms to a required shape and size of the frame 1, after which the middle sheet 11 is attached to the transparent acrylic plate 13. Through a vacuum suction method, the transparent acrylic plate 13 and the middle sheet 11 are positioned within a mold cavity 1021 of a female mold part 102 of the mold 100 and cooperate with an inner wall of the male mold part 103 of the mold 100 to define a receiving space 120. Subsequently, using an in-mold injection technique, a material is injected into the mold 100 to fill the receiving space 120 and form the plastic frame 12. Through the design of the mold 100, an outer peripheral edge of the plastic frame 12 covers a peripheral edge of the acrylic plate 13 and adheres to the middle sheet 11, such that the middle sheet 11 is sandwiched between the plastic frame 12 and the transparent acrylic plate 13.

Although the conventional method can use the in-mold injection forming method to directly accomplish assembly of the monitor frame 1, it has the following disadvantages:
1. Prior to the in-mold injection forming, the mold 100 must be made first such that it conforms to the monitor size and a predetermined shape of the frame 1. After the middle sheet 11 and the plastic acrylic plate 13 are positioned within the mold cavity 1021, the receiving space 120 must be provided for forming of the plastic frame 12. Since the receiving space 120 is narrow, a small difference may lead to failure in the manufacture of the mold 100. Further, since the middle sheet 11, the plastic frame 12, and the plastic acrylic plate 13 are thin sheet bodies, accuracy of the size of the mold 100 is needed to smoothly form the plastic frame 12. Hence, these drawbacks result in a high cost of production for making the mold 100, which in turn, results in a high manufacturing cost of the frame 1.
2. Because the transparent acrylic plate 13 and the middle sheet 11 are positioned in the mold cavity 1021 only through the vacuum suction method, and because the receiving space 120 is defined to be small and narrow by the transparent acrylic plate 13, the middle sheet 11, and the inner wall of the male mold part 103, the transparent acrylic plate 13 and the middle sheet 11 may be easily deformed due to impact or pressure when the material is injected into the mold 100. Further, since the receiving space 120 is small and narrow, the material injected into the mold 100 may not easily and completely fill the receiving space 120 to form the plastic frame 12. Moreover, the curved structures at the two opposite lateral sides of the transparent acrylic plate 13 complicate forming of the plastic frame 12, which may increase the damage rate to more than 30%. Hence, the conventional method has high manufacturing costs because of its high damage rate, which limits potential economic benefits.
3. Coping with the trend of consumers' preferences for uniqueness and individuality, an electronic product must provide practical functions and diversity in appearance to satisfy the demands of a consumer. Hence, the production process changes from standardized mass production to diversified small-quantity production. Because the conventional manufacturing method using in-mold injection forming must shoulder expensive costs of making molds and repairs associated with its excessive rate of damage, the conventional method loses its competitive advantage when manufacturing costs are increased due to shifts to smaller quantity production.

Therefore, an object of the present invention is to provide a method of making a monitor frame that has a simple production process and that is flexible and easy to perform diversified small-quantity production to effectively minimize the production costs.

According to this invention, a method of making a monitor frame according to the preferred embodiment of the present invention comprises the steps of: producing separately a transparent plate made of plastic, a middle sheet, and a looped framing plate made of plastic and defining a frame opening, the middle sheet having a middle opening extending through opposite first and second surfaces of the middle sheet; attaching the second surface of the middle sheet to a press face of a tool through a vacuum suction force; moving the press face of the tool to abut against the transparent plate and press the middle sheet against the transparent plate such that the first surface of the middle sheet is adhered flatly to the transparent plate; moving the tool away from the second surface of the middle sheet; and adhering the looped framing plate to the second surface of the middle sheet such that the frame opening is aligned with the middle opening.

Other features and advantages of the present invention will become apparent in the following detailed description of the preferred embodiment of the invention, with reference to the accompanying drawings, in which:
Fig. 1 is a perspective view of a conventional monitor frame made according to a conventional method;
Fig. 2 is a sectional view, illustrating how a plastic frame of the conventional monitor frame is assembled with a middle sheet and a transparent acrylic plate thereof by using an in-mold injection method;
Fig. 3 is a flow chart, illustrating the steps involved in a method of making a monitor frame according to the preferred embodiment of the present invention;
Fig. 4 is an exploded perspective view of the monitor frame of the preferred embodiment;
Fig. 5 is a sectional view, illustrating how a middle sheet is adhered to a transparent plate using a press-fit jig;
Fig. 6 is a sectional view, illustrating the monitor frame made according to the method of the present invention; and
Fig. 7 is a flow chart, illustrating the alternative steps involved in the method of making the monitor frame of the present invention.

The above-mentioned and other technical contents, features, and effects of this invention will be clearly presented from the following detailed description of a preferred embodiment in coordination with the reference drawings.

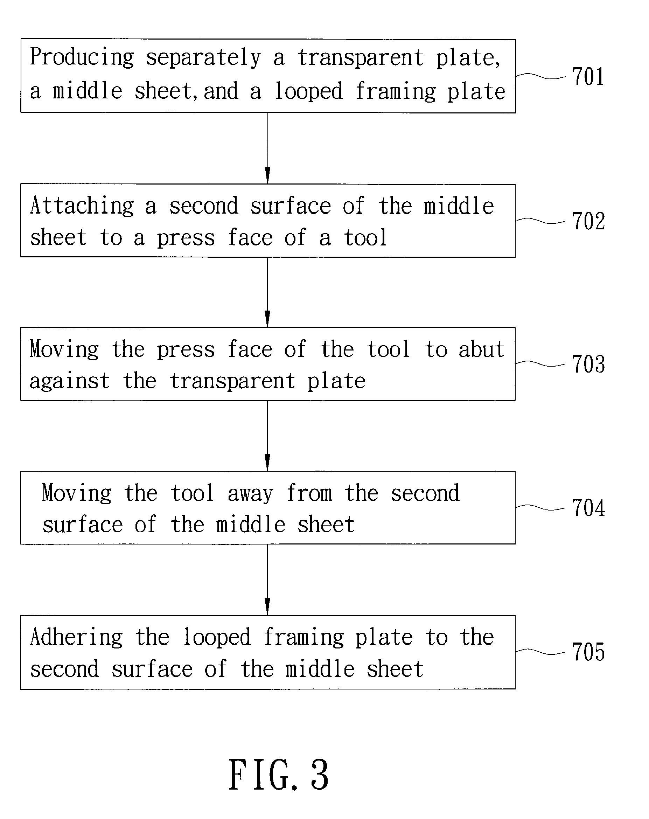

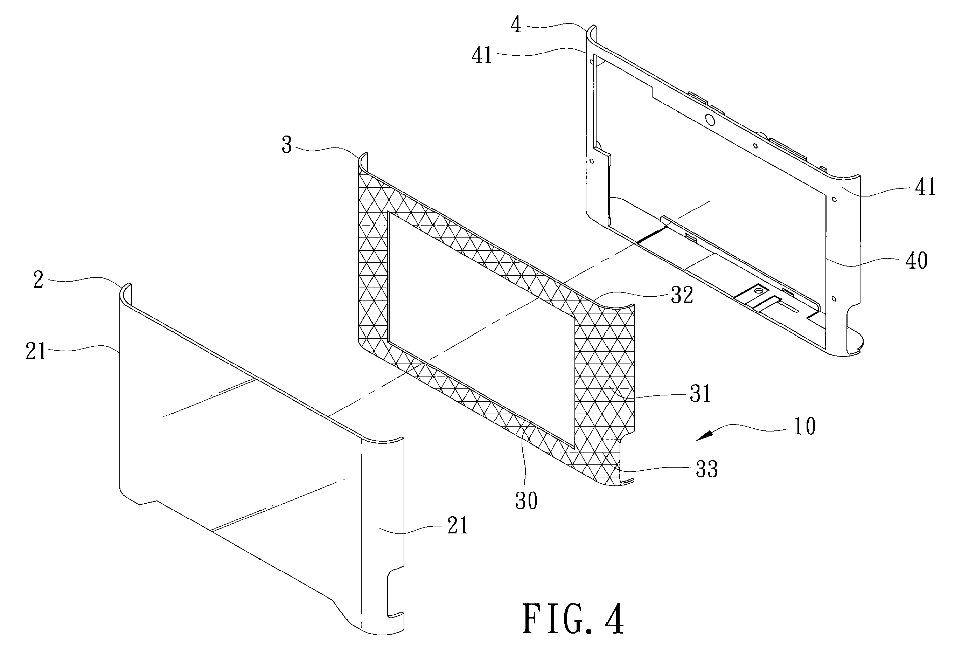

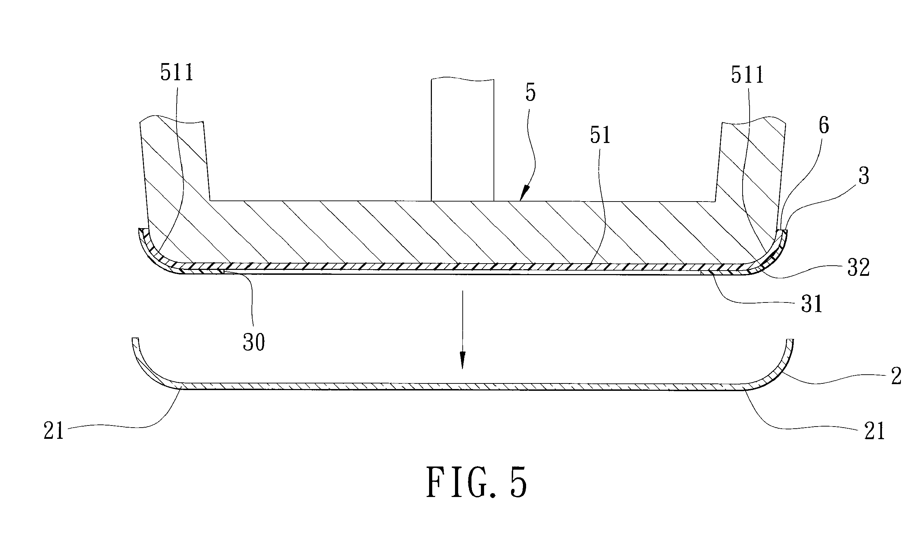

Referring to Figs. 3 to 6, a method of making a monitor frame 10 according to the preferred embodiment of the present invention includes steps 701 to 705.

In step 701, a transparent plate 2, a middle sheet 3, and a looped framing plate 4 are produced separately. In this embodiment, the transparent plate 2 is configured as a transparent acrylic plate, and the looped framing plate 4 is made of plastic. The looped framing plate 4 has a frame opening 40. The middle sheet 3 has opposite first and second surfaces 31, 32, and a middle opening 30 extending through the first and second surfaces 31, 32 for alignment with the frame opening 40.

Preferably, to enhance variation of appearance and to present different designs, a pattern 33 is provided on the first surface 31 of the middle sheet 3. The pattern 33 can be made according to a design requirement by embossing or printing a particular pattern on the first surface 31. Further, the transparent plate 2 includes two opposite first curved end portions 21, and the looped framing plate 4 includes two second curved end portions 41 corresponding to the first curved end portions 21. Through such a configuration, the two opposite curved end portions can enhance the appearance and safe use of the produced monitor frame 10.

In step 702, the second surface 32 of the middle sheet 3 is attached to a press face 51 of a tool, such as a press-fit jig 5, through a vacuum suction force. The transparent plate 2 is placed below the press-fit jig 5 aligned with the first surface 31 of the middle sheet 3.

In step 703, the press face 51 of the press-fit jig 5 is moved toward the transparent plate 2 until the first surface 31 of the middle sheet 3 abuts against the transparent plate 2. The press face 51 continues to press the middle sheet 3 against the transparent plate 2 such that the first surface 31 of the middle sheet 3 is completely adhered to the transparent plate 2.

In step 704, the press-fit jig 5 is moved away from the second surface 32 of the middle sheet 3. In this embodiment, the press face 51 of the press-fit jig 5 has a shape and a size corresponding to that of the transparent plate 2, and has two curved end portions 511 corresponding to the first curved end portions 21 of the transparent plate 2. The middle sheet 3 is attached to and extends along the length of the press face 51. When the middle sheet 3 abuts against the transparent plate 2, since two opposite end portions of the middle sheet 3 completely adapt to the curvatures of the curved end portions 21 of the transparent plate 2, the middle sheet 3 can be smoothly and tightly adhered to the transparent plate 2.

Since the middle sheet 3 is a thin sheet article, to enhance adhesion stability and to prevent deformation of the middle sheet 3, the middle sheet 3 may be first adhered to a substrate 6 before the middle sheet 3 is attached to the press face 51 of the press-fit jig 5. The substrate 6 has a shape similar to that of the transparent plate 2, and is lightweight. With the substrate 6 supporting the middle sheet 3, the substrate 6 together with the middle sheet 3 are attached to the press face 51 of the press-fit jig 5 to facilitate adhesion of the middle sheet 3 to the transparent plate 2. To minimize formation of bubbles and damaged goods, the substrate 6 used in this embodiment is a cardboard. The middle sheet 3 is first sucked onto the cardboard substrate 6, and is then adhered to the transparent plate 2, after which the substrate 6 is moved away from the middle sheet 3. By forming the cardboard substrate 6 into a shape similar to that of the transparent plate 2, and through the fact that cardboard is not easily deformed, the substrate 6 can assist the middle sheet 3 in adhering tightly to the transparent plate 2. Hence, formation of bubbles can be reduced to a great extent.

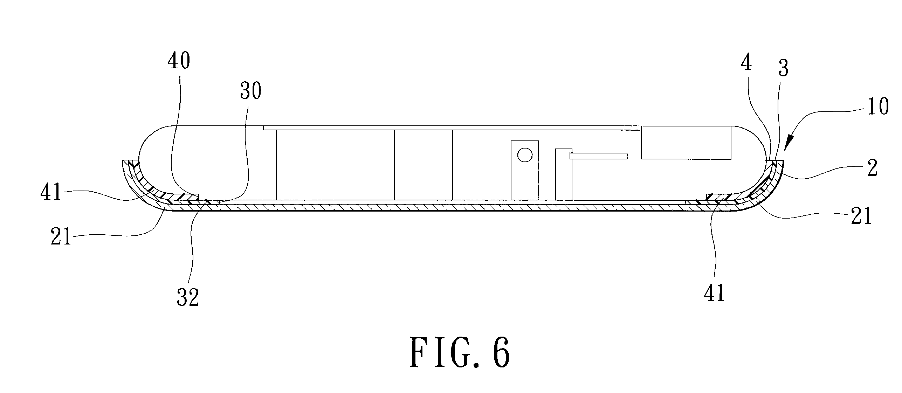

With reference to Fig. 6, in step 705, the looped framing plate 4 is adhered to the second surface 32 of the middle sheet 3, thereby forming the monitor frame 10. The monitor frame 10 may be installed on a palm-sized game device, a car TV, a cellphone, a notebook computer, and other movable electronic products. However, use of the monitor frame 10 is not limited to the aforesaid disclosures.

In this embodiment, the sequence of assembly of the monitor frame 10 involves adhering the middle sheet 3 to the transparent plate 2, after which the looped framing plate 4 is adhered to the middle sheet 3. Alternatively, the middle sheet 3 may be first adhered to the looped framing plate 4 using other type of press-fit jig, after which the transparent plate 2 is adhered to the middle sheet 3. That is, the middle sheet 3 may be adhered first to the transparent plate 2 or to the looped framing plate 4 depending on the press-fit jig used. The required monitor frame 10 can be similarly made.

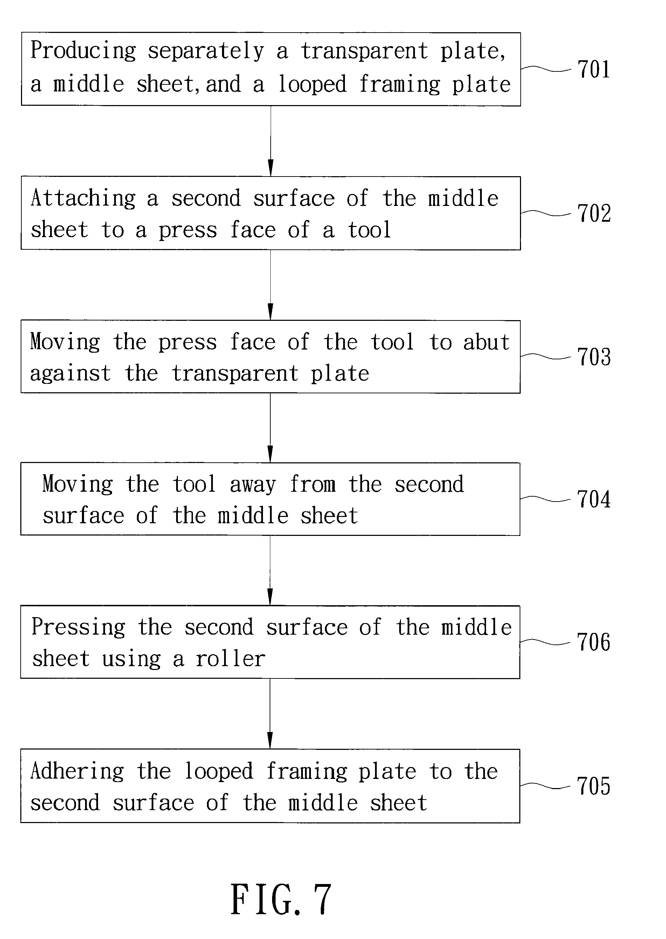

It is worth mentioning that the monitor frame 10 may be a flat plate without the curved end portions, and both of the transparent plate 2 and the looped framing plate 4 are entirely flat. Further, the press face 51 of the press-fit jig 5 has a shape corresponding to that of the transparent plate 2 which is flat. In this case, as shown in Fig. 7, step 706 may be inserted between steps 704 and 705. In step 706, after the press-fit jig 5 is moved away from the second surface 32 of the middle sheet 3, a roller (not shown) is pressed against and is rolled along the second surface 32 of the middle sheet 3 to push out bubbles between the middle sheet 3 and the transparent plate 2, thereby pressing and adhering tightly the middle sheet 3 to the transparent plate 2.

Additionally, the connection among the transparent plate 2, the middle sheet 3, and the looped framing plate 4 may be varied. For example, an adhesive material may be coated to surfaces between the transparent plate 2 and the middle sheet 3 and between the middle sheet 3 and the looped framing plate 4, or a double-sided adhesive tape may be provided among the transparent plate 2, the middle sheet 3, and the looped framing plate 4, thereby completing assembly of the monitor frame 10. Further, an inter-engaging structure may be provided between the transparent plate 2 and the looped framing plate 4 so that the middle sheet 3 may be sandwiched and positioned between the transparent plate 2 and the looped framing plate 4. Similarly, the monitor frame 10 may be obtained.

From the aforesaid description, the advantages and efficiencies of the method of making the monitor frame 10 according to the present invention are as follows:
1. By producing separately the transparent plate 2, the middle sheet 3, and the looped framing plate 4 so that they can be first made to conform to the specification smoothly, structural defects can be effectively prevented, thereby minimizing rate of product damage. Afterwards, through the press-fit jig 5 or in coordination with the substrate 6, the middle sheet 3 can be pressed evenly to adhere to the transparent plate 2 or the looped framing plate 4, thereby effectively preventing formation of bubbles during the adhering process. Similarly, damage to the product can be effectively prevented. Since the aforesaid method does not require accurate and costly manufacture of molds, the manufacturing costs of the present invention can be effectively reduced to a minimum.
2. Since the transparent plate 2, the middle sheet 3, and the looped framing plate 4 are first made individually and then interconnected to each other, the required shape and size of the monitor frame 10 can easily be complied with by adjusting the specification of each of the transparent plate 2, the middle sheet 3, and the looped framing plate 4. Hence, the manufacturing process of the present invention is simple, the product yield rate can be easily controlled, and the product is flexibly adjustable to be capable of coping with the specification of the product. Unlike the in-mold injection method, the present invention is suitable for making diversified small-quantity production, and can reduce manufacturing costs to a minimum, thereby conferring economic benefits. Further, the product produced using the method of the present invention can satisfy a consumer's demand for beautiful variation in design at a cheap price.
3. The method of the present invention can effectively reduce formation of bubbles during manufacture of the monitor frame 10, whether the monitor frame 10 is flat or with curved end portions, which permits a good production yield to be obtained.

## Claims

1. A method of making a monitor frame (10), **characterized by**:
producing separately a transparent plate (2) made of plastic, a middle sheet (3), and a looped framing plate (4) made of plastic and defining a frame opening (40), the middle sheet (3) having a middle opening (30) extending through opposite first and second surfaces (31, 32) of the middle sheet (3);
attaching the second surface (32) of the middle sheet (3) to a press face (51) of a tool (5) through a vacuum suction force;
moving the press face (51) of the tool (5) to abut against the transparent plate (2) and press the middle sheet (3) against the transparent plate (2) such that the first surface (31) of the middle sheet (3) is adhered flatly to the transparent plate (2);
moving the tool (5) away from the second surface (32) of the middle sheet (3); and
adhering the looped framing plate (4) to the second surface (32) of the middle sheet (3) such that the frame opening (40) is aligned with the middle opening (30).

2. The method of claim 1, **characterized in that** the press face (51) of the tool (5) has a shape and a size corresponding to that of the transparent plate (2).

3. The method of claim 1 or claim 2, further **characterized by** the step of pressing the second surface (32) of the middle sheet (3) using a roller after the tool (5) is moved away from the second surface (32) of the middle sheet (3), thereby
pressing and adhering the first surface (31) to the transparent plate (2), wherein both of the transparent plate (2) and the looped framing plate (4) are entirely flat.

4. The method of any preceding claim, **characterized in that** the transparent plate (2) includes two opposite first curved end portions (21), and said looped framing plate (4) includes two second curved end portions (41) corresponding to the first curved end portions (21).

5. The method of any preceding claim, further **characterized by** the step of adhering the middle sheet (3) to a substrate (6) before the middle sheet (6) is attached to the press face (51) of the tool (5), and attaching the substrate (6) together with the middle sheet (3) to the press face (51) of the tool (5), the substrate (6) having a shape similar to that of the transparent plate (2) and having lightweight.

6. The method of claim 5, **characterized in that** the substrate (6) is cardboard.

7. The method of any preceding claim, **characterized in that** the middle sheet (3) further has a pattern (33) provided on the first surface (31) thereof.
